# EUROPEAN PATENT SPECIFICATION

(11) **EP 0 408 754 B1**
(45) Date of publication and mention of the grant of the patent: **16.08.1995**
(21) Application number: 89911603.2
(22) Date of filing: 24.10.1989
(51) Int. Cl.: H04N 7/087, H04N 9/79, H03M 13/22

(54) **INTERFRAME DEINTERLAVE SWITCHING CIRCUIT**
INTERFRAME-ENTSCHACHTELUNGSUMSCHALTKREIS
CIRCUIT DE COMMUTATION DE DESENTRELACEMENT INTERTRAME

(30) Priority: 24.10.1988 JP 267449/88
(43) Date of publication of application: 23.01.1991
(73) Proprietor: MATSUSHITA ELECTRIC INDUSTRIAL CO., LTD., Kadoma-shi, Osaka-fu, 571 (JP); NIPPON HOSO KYOKAI, Tokyo 150 (JP)
(72) Inventor: OKUMURA, Naoji, Osaka 567 (JP); MIYOSHI, Toshihiro 17-4-202, Tsurumachi 1-chome, Osaka 551 (JP); NINOMIYA, Yuichi 17-4, Takaishi 2-chome, Kanagawa 215 (JP); OHMURA, Toshiro, Tokyo 181 (JP)
(74) Representative: Votier, Sidney David
(86) International application number: PCT/JP89/01086
(87) International publication number: WO 90/04905

(56) References cited:
- EP-A- 0 222 386
- EP-A- 0 276 809
- EP-A- 0 338 781
- EP-A- 0 342 833
- EP-A- 0 348 132
- JP-A- 5 999 892
- JP-A- 6 327 181
- IEEE TRANSACTIONS ON BROADCASTING. vol. 33, no. 4, 30 December 1987, NEW YORK, US pages 130 - 160; Y.NINOMIYA ET AL: 'An HDTV Broadcasting System Utilizing a Bandwidth Compression Technique MUSE'
- NHK LABORATORIES NOTE. no. 358, 30 April 1988, TOKYO JP pages 1 - 12; T.TAKEGAHARA ET AL: 'Sound Transmission System Using Baseband Time Division Multiplexing for MUSE system HDTV'
- NHK LABORATORIES NOTE. no. 282, 30 November 1982, TOKYO JP pages 1 - 13; T.YOSHINO ET AL: 'PCM Sounds on digital subcarrier in Television for a SatelliteBroadcasting System'
- PATENT ABSTRACTS OF JAPAN vol. 7, no. 255 (E-210)12 November 1983

## Description

### Technical Field

The present invention relates to an interframe deinterleave switching circuit which is capable of automatically switching an interleaving length in interframe deinterleaving operation performed in a high definition television broadcasting system (MUSE system).

### Background Art

An interframe deinterleaving circuit is employed as one of means for dispersing a burst error in the PCM voice signal of the high definition television broadcasting. However, because there is a possibility of employing different interleaving lengths between a transmission system and a package system and therefore a necessity for their switching arises, an interframe deinterleave switching circuit is now under consideration.

Then, the description will be directed to an example of the foregoing conventional interframe deinterleave switching circuit with reference to the drawings.

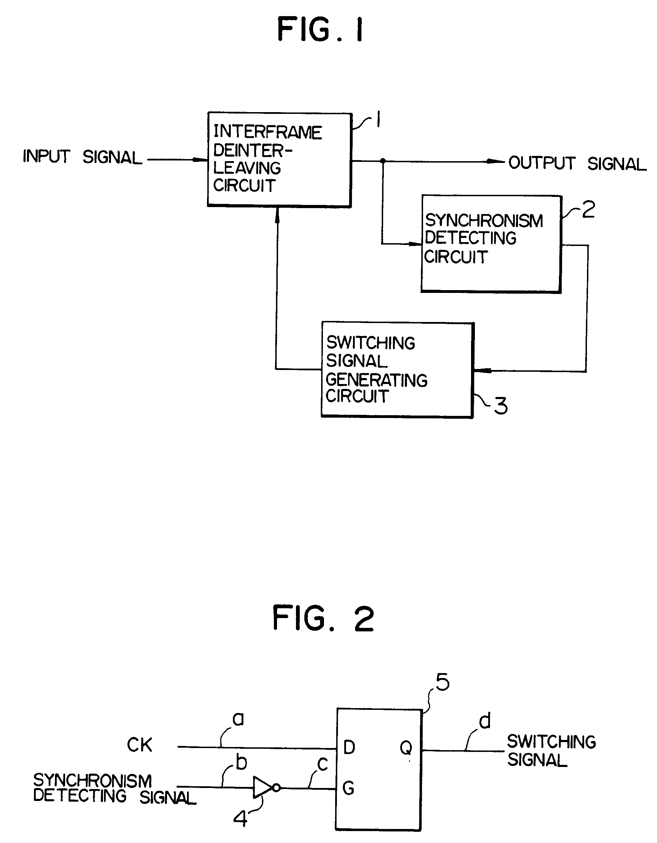

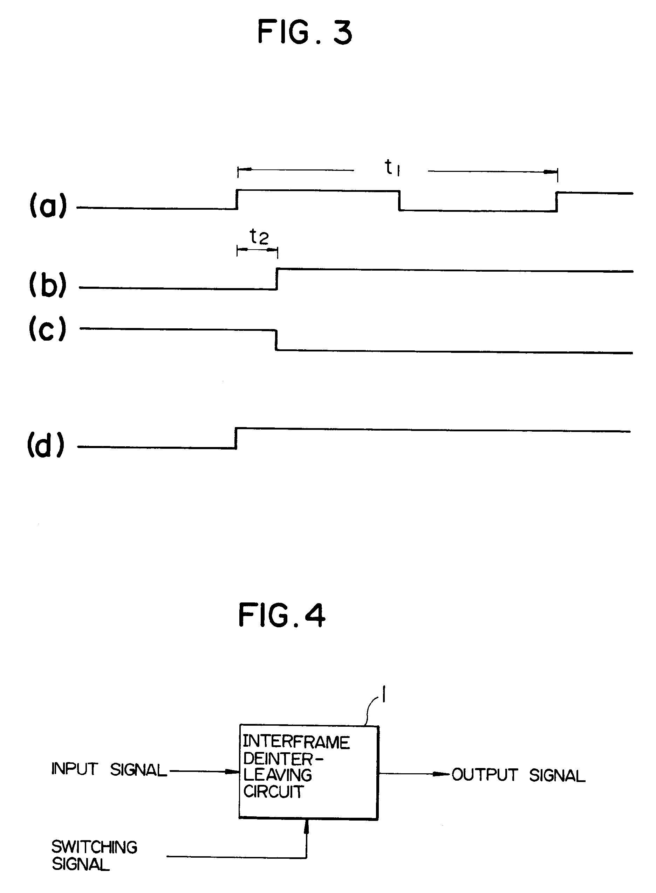

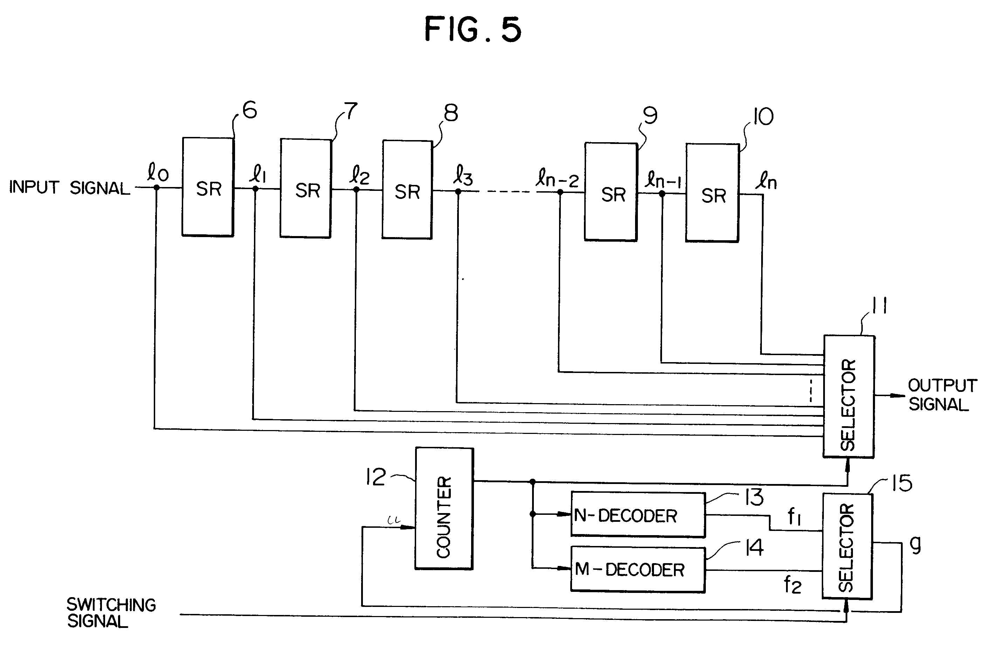

Fig. 4 is a block diagram showing a conventional interframe deinterleave switching circuit and Fig. 5 shows an example of an interframe deinterleaving circuit. In Fig. 4, 1 denotes an interframe deinter-leaving circuit. In Fig. 5, 6 to 10 denote shift registers, 11 denotes a selector, 12 denotes a counter, 13 denotes an n-decoding circuit, 14 denotes an m-decoding circuit, and 15 denotes a selector.

Hereinafter, the description will be directed to the operation of the interframe deinterleave switching circuit having the foregoing arrangement.

An input signal is passed through n ones of the shift registers 6 to 10, each of which corresponds to one-frame of 1350 clocks of a voice signal. These shift registers thus serve to supply the resulting signals 1₀, 1₁, 1₂, 1₃, ... ... 1ₙ₋₂, 1ₙ₋₁, 1ₙ including the input signal 1₀.

And, a counter 12 starts to count at an initial value and sends out the output to a n-decode circuit 13. When the n-decode circuit 13 converts the output into n, a CLEAR signal f₁ appears. When the m-decode circuit 14 converts the output into m (m<n), a CLEAR signal f₂ appears. Then, the selector 15 switches f₁ to f₂ in response to a switching signal from the external unit and send out the output g to the counter 12 for clearing it.

When f₁ is conveyed on the switching signal, the counter 12 repeats counts of 0 to n. And, the selector 11 serves to sequentially select one of the input signal 1₀ and those outputs 1₁, 1₂, to 1ₙ₋₁, 1ₙ of the shift registers 6 to 10 in response to the output of the counter 12.

The foregoing arrangement, however, has a disadvantage that it is necessary to pick up a switching signal for an interleave signal from the external unit.

EP-A-0 222 386 discloses a PCM audio signal recording and reproducing apparatus which samples an audio signal accompanying a video signal, converts it to a PCM signal, adds error detection correction data to a predetermined number of PCM data, forms a data frame by those signals, modulates it in accordance with a predetermined modulation system, and records the audio signal together with the video signal or singly on a record medium by using a rotary head type scanner. A digital signal processing circuit having a memory with a predetermined capacity is provided, and the number of digital data to be recorded in one data frame is varied in accordance with a difference between the number of input data of the digital audio signal to the digital signal processing circuit and the number of output data supplied to the record medium for recording. In the recording mode, the PCM audio signal is sectioned into blocks, a data block address signal is added to each block to indicate a relative order to other blocks. An interleave block address signal is added to each of blocks in a block set which comprises a predetermined number of blocks for effecting signal processing such as interleaving and deinterleaving, to indicate a relative order of the block to other blocks, said block completing in a period synchronized with the sampling frequency. The interleave block address signal and an identification signal are added to alternate blocks.

An object of the invention is to provide an interframe deinterleave switching circuit which is capable of automatically switching an interleaving length without requiring a switching signal from the outside.

The features of the invention are defined in Claim 1.

### Brief Description of Drawings

Fig. 1 is a block diagram showing an interframe deinterleaving circuit according to an embodiment of the invention;
Fig. 2 is a circuit diagram showing a concrete switching signal generating circuit;
Fig. 3 is a view showing some timings of the switching signal generating circuit;
Fig 4 is a block diagram showing the conventional interframe deinterleave switching circuit; and
Fig. 5 is a circuit diagram showing a concrete interframe deinterleaving circuit.

### Best Mode for Carrying Out the Invention

Hereinafter, the description will be directed to one embodiment of an interframe deinterleave switching circuit with reference to the drawings. Fig. 1 is a block diagram showing an interframe deinterleave switching circuit according to the embodiment of the invention, Fig. 2 is a circuit diagram showing a concrete circuit of a switching signal generating circuit, and Fig. 3 is a view showing some timings.

In Fig. 1, 1 denotes an interframe deinter-leaving circuit, 2 denotes a synchronism detecting circuit for detecting a voice synchronizing signal, 3 denotes a switching signal generating circuit for generating a switching signal, which serves as switching interleaving length, 4 denotes an inverter circuit for inverting a synchronism detecting signal, and 5 denotes a D-latch circuit for generating a switching signal.

The operation of the interframe deinterleave switching circuit having the foregoing arrangement will be described with reference to Figs. 1, 2, and 3.

An input signal is supplied to the interframe deinterleaving circuit 1 in which the signal is subject to the interframe deinterleaving operation with an interleaving length m. Next, the resulting output is supplied to the synchronism detecting circuit 2 in which a voice synchronizing signal is detected from the output. The synchronism detecting circuit 2 serves to supply as a synchronism detecting signal b a HIGH level signal when it is detected and a LOW level signal when it is not detected. Next, in the switching signal generating circuit 3, the synchronism detecting signal b is inverted in the inverter circuit 4 and results in being a signal c shown in Fig. 3. In the D-latch circuit 5, an input clock a is straightforward used as a switching signal d when the synchronism detecting signal c is at HIGH level, that is, the synchronism detecting circuit 2 cannot detect a voice synchronizing signal. It means that the switching signal d is inverted and thus the interleaving length is changed to n. When the synchronism detecting signal is at LOW level, that is, the synchronism detecting circuit 2 can detect a voice synchronizing signal, the D-latch circuit 5 serves to supply a clock a given at a time point when the synchronism detecting signal c is at LOW level and the switching signal keeps the voice synchronizing signal detected by the synchronism detecting circuit 2. The period t₁ of the clock a has to meet the following relation with a time t₂ extending from the change of the switching signal d to the enabling time to detect the synchronism:
t₁/2 > t₂

As mentioned above, the present embodiment provides the synchronism detecting circuit 2 for detecting a voice synchronizing signal and the switching signal generating circuit 3 in order to switch the switching signal for switching the interleaving length.

### Industrial Applicability

According to the present invention, the provision of the synchronism detecting circuit and the switching signal generating circuit makes it possible to automatically switch interleaving length without requiring a switching signal from the external unit.

### List of reference numbers in the drawings

1 ... ... interframe deinterleaving circuit
2 ... ... synchronism detecting circuit
3 ... ... switching signal generating circuit
4 ... ... inverter circuit
5 ... ... D-latch circuit

## Claims

1. An interframe deinterleave switching circuit for switching a deinterleaving length for a digitally encoded signal having two different interleaving lengths between a transmission system and a package system, said circuit comprising:
an interframe deinterleaving circuit (1) for changing the deinterleaving length for said digitally encoded signal; characterised by:
a synchronism detecting circuit (2) for detecting a synchronizing signal from an output of said interframe deinterleaving circuit (1); and
a switching signal generating circuit (3) for generating a switching signal which causes said interframe deinterleaving circuit (1) to maintain the deinterleaving length when said synchronism detecting circuit (2) detects the synchronizing a signal, and which causes said interframe deinterleaving circuit (1) to change the deinterleaving length when said synchronism detecting circuit (2) detects no synchronizing signal.

2. The interframe deinterleave switching circuit according to Claim 1, wherein
said switching signal generating circuit includes an inverter circuit (4) for inverting an output signal (b) of said synchronism detecting circuit (2) and a D-latch circuit (5) for receiving a clock signal (a) and an output signal (c) of said inverter circuit (4) and for holding, when said synchronism detecting circuit (2) detects the synchronizing signal, the clock signal (a) so as to output a held signal (d) as said switching signal and for outputting the clock signal (a) as said switching signal when said synchronism detecting circuit (2) detects no synchronizing signal.

## Patentansprüche

1. Interframe-Entschachtelungs-Umschaltkreis zum Umschalten einer Entschachtelungslänge für ein digital kodiertes Signal mit zwei verschiedenen Schachtelungslängen zwischen einem Übertragungssystem und einem Packsystem, wobei der Schaltkreis aufweist:
einen Interframe-Entschachtelungskreis (1) zum Ändern der Entschachtelungslänge für das digital kodierte Signal;
gekennzeichnet durch
eine Synchronismuserfassungsschaltung (2) zum Erfassen eines Synchronisiersignals von einem Ausgangsanschluß des Interframe-Entschachtelungskreises (1); und
einen Schaltsignalerzeugungskreis (3) zum Erzeugen eines Schaltsignals, das den Interframe-Entschachtelungskreis die Entschachtelungslänge halten läßt, wenn die Synchronismuserfassungsschaltung (2) ein Synchronisiersignal erfaßt, und das die Interframe-Entschachtelungsschaltung (1) die Entschachtelungslänge ändern läßt, wenn die Synchronismuserfassungsschaltung (2) kein Synchronisiersignal erfaßt.

2. Interframe-Entschachtelungs-Umschaltkreis nach Anspruch 1, bei dem
der Schaltsignalerzeugungskreis eine Invertierschaltung (4) zum Invertieren eines Ausgangssignals (b) der Synchronismuserfassungsschaltung (2) und eine D-Latch-Schaltung (5) zum Empfangen eines Taktsignals (a) sowie eines Ausgangssignals (c) der Invertierschaltung (4) und zum Halten des Taktsignals (a), um ein Haltesignal (d) als das Schaltsignal abzugeben, wenn die Synchronismuserfassungsschaltung (2) das Synchronisiersignal erfaßt, sowie zum Abgeben des Taktsignals (a) als das Schaltsignal beeinhaltet, wenn die Synchronismuserfassungsschaltung (2) kein Synchronisiersignal erfaßt.

## Revendications

1. Circuit de commutation de désentrelacement entre trames pour commuter une longueur de désentrelacement, pour un signal codé numériquement ayant deux longueurs d'entrelacement différentes, entre un système de transmission et un système de modules, ledit circuit comprenant un circuit de désentrelacement entre trames (1) pour changer la longueur de désentrelacement pour ledit signal codé numériquement,
caractérisé par:
un circuit de détection de synchronisme (2) pour détecter un signal de synchronisation issu d'une sortie dudit circuit de désentrelacement entre trames (1); et
un circuit générateur de signal de commutation (3) pour générer un signal de commutation qui amène ledit circuit de désentrelacement entre trames (1) à maintenir la longueur de désentrelacement lorsque ledit circuit de détection de synchronisme (2) détecte le signal de synchronisation, et qui amène ledit circuit de désentrelacement entre trames (1) à changer la longueur de désentrelacement lorsque ledit circuit de détection de synchronisme (2) ne détecte pas de signal de synchronisation.

2. Circuit de commutation de désentrelacement entre trames selon la revendication 1, dans lequel
ledit circuit générateur de signal de commutation contient un circuit inverseur (4) pour inverser un signal de sortie (b) dudit circuit de détection de synchronisme (2) et un circuit à verrouillage D (5) pour recevoir un signal d'horloge (a) et un signal de sortie (c) dudit circuit inverseur (4) et pour maintenir, lorsque ledit circuit de détection de synchronisme (2) détecte le signal de synchronisation, le signal d'horloge (a) de manière à délivrer un signal maintenu (d) constituant ledit signal de commutation, et pour délivrer le signal d'horloge (a) constituant ledit signal de commutation lorsque ledit circuit de détection de synchronisme (2) ne détecte pas de signal de synchronisation.
